# EUROPÄISCHE PATENTSCHRIFT

(11) **EP 2 110 850 B1**
(45) Veröffentlichungstag und Bekanntmachung des Hinweises auf die Patenterteilung: **22.04.2015**
(21) Anmeldenummer: 09008647.1
(22) Anmeldetag: 02.12.2004
(51) Int. Cl.: H01L 23/10, H01L 21/50, H01L 21/60, H01S 5/042, H01L 21/98

(54) **Vorrichtung zur wechselseitigen Kontaktierung von zwei Wafern**
Device for the mutual contacting of two wafers
Dispositif pour mettre deux tranches de semi-conducteur en contact mutuel

(30) Priorität: 03.12.2003 DE 10357027; 23.12.2003 DE 10361521
(43) Veröffentlichungstag der Anmeldung: 21.10.2009
(62) Teilanmeldung aus: 04802856.7
(73) Patentinhaber: Pac Tech - Packaging Technologies GmbH, 14641 Nauen (DE)
(72) Erfinder: Zakel, Elke, 14641 Nauen (DE); Azdasht, Ghassem, 13591 Berlin (DE)
(74) Vertreter: Tappe, Hartmut

(56) Entgegenhaltungen:
- EP-A- 1 346 949
- DE-A1- 4 234 342
- DE-A1- 19 749 909
- DE-A1- 19 751 487
- US-A- 4 963 714
- "Selektives Loeten mit Hochleistungs-Diodenlasern: Auf den Prozess abgestimmt", ELEKTRONIK, PRODUKTION & PRÜFTECHNIK, LEINFELDEN-ECHTERDINGEN : KONRADIN-VERL. ROBERT KOHLHAMMER, DE, Nr. November, 1. November 2000 (2000-11-01), Seite 50,52, XP009151846, ISSN: 0943-0962
- TAO Y ET AL: "INVESTIGATION OF LASER-ASSISTED BONDING FOR MEMS PACKAGING", INTERNATIONAL JOURNAL OF NONLINEAR SCIENCE AND NUMERICAL SIMULATION, FREUND PUNLISHING HOUSE, TEL-AVIV, IL, Bd. 3, Nr. 3/4, 11. August 2002 (2002-08-11), Seiten 427-431, XP009023464, ISSN: 1565-1339
- MESCHEDER U M ET AL: "Local laser bonding for low temperature budget", SENSORS AND ACTUATORS A, ELSEVIER SEQUOIA S.A., LAUSANNE, CH, Bd. 97-98, 1. April 2002 (2002-04-01), Seiten 422-427, XP004361631, ISSN: 0924-4247

## Beschreibung

Die vorliegende Erfindung betrifft eine Vorrichtung zur wechselseitigen Kontaktierung von zwei waferartigen Bauelement-Verbundanordnungen aus einer Vielzahl zusammenhängend ausgebildeter gleichartiger Bauelemente, insbesondere eines Halbleiter-Wafers mit einem Funktionsbauelement-Wafer, zur Herstellung von elektronischen Baugruppen auf Wafer-Ebene nach Anspruch 1.

Die Vorrichtung der vorgenannten Art kommt ganz allgemein dann zur Anwendung, wenn es darum geht, in einem Verbund zusammenhängend ausgebildete Substrate mit ebenfalls in einem Verbund angeordneten Bauelementen ohne vorhergehende Auflösung des jeweiligen Verbunds miteinander zu verbinden.

Zur Herstellung elektronischer Baugruppen auf Chipebene ist es bekannt, Chips bzw. Chipmodule mit den über die Chips angesteuerten Funktionsbauelementen, wie beispielsweise eine Laserdiode, sowohl den Chip als auch die Laserdiode auf Wafer-Ebene, also in einem zusammenhängenden Wafer-Verbund, herzustellen und anschließend vor Kontaktierung des Chips mit der Laserdiode sowohl den Chip als auch die Laserdiode aus dem jeweiligen Wafer-Verbund zu vereinzeln. Hieraus ergibt sich die Notwendigkeit, einen zur Kontaktierung des Chips mit der Laserdiode notwendigen Positionierungs- und Verbindungsvorgang entsprechend der Anzahl der Chips bzw. der Laserdioden separat und wiederholt durchzuführen.

Je nach Art und Ausführung des für die Kontaktierung mit dem Chip vorgesehenen Funktionsbauelements erweist es sich überdies noch als erforderlich, ein Kontaktierungsverfahren sicherzustellen und entsprechend zu überwachen, bei dem die Temperaturbelastung des Funktionsbauelements in vorgegebenen Grenzen bleibt. Diese Grenzen sind insbesondere bei sehr temperaturanfälligen Funktionsbauelementen, wie beispielsweise Kunststoffmikrolinsen, sehr niedrig, so dass bei jedem einzelnen Kontaktierungsvorgang zwischen dem Chip und dem Funktionsbauelement für eine Begrenzung der bei dem Kontaktierungsvorgang im Funktionsbauelement erreichten Temperatur, beispielsweise durch entsprechende Kühlmaßnahmen, zu sorgen ist.

Bekannt ist aus der EP 1 346 949 A eine Vorrichtung zum Verbinden einer Abdeckkappe mit einem Wafer, auf den ein mikroelektromechanisches System aufgebracht ist. Dabei wird mittels Laserenergie ein versiegelter Hohlraum zum Schutz des mikroelektromechanischen Systems geschaffen. Die Vorrichtung weist einen Aufnahmerahmen auf, der transparent sein kann, um Laserstrahlen passieren zu lassen, die von außerhalb dieses Aufnahmerahmens angeordneten Laserquellen ausgesendet werden. Diese Laserquellen sind nicht gruppenweise aktivierbar.

Die DE 42 34342 A1 zeigt ein Verfahren zur Materialbearbeitung mit Laserstrahlung, bei dem eine Vielzahl von Laserdioden in einer hohen Packungsdichte mit geeigneter Strahlformung- und -führung kombiniert wird, um die für die Materialbearbeitung erforderlichen hohen Intensitäten zu erzeugen. Auf Grund der hohen Leistungsdichten eignet sich dieses Verfahren weniger im Bereich der Wafer-basierten Verbindungstechniken in Verbindung mit temperaturempfindlichen Baugruppen.

Die US 4 963 714 A zeigt eine Lötvorrichtung zur Verlötung von integrierten Halbleiter-Schaltkreisen auf Leiterplatten. Dabei wird zur Erhöhung der Strahlungsintensität an der Lötstelle die Strahlung mehrerer Laserquellen über Glasfaserkabel und mit optischen Vorrichtungen zu einem Bündel zusammengefasst und mehrere Bündel gleichzeitig auf verschiedene Lötstellen gerichtet.

Der vorliegenden Erfindung liegt nun die Aufgabe zugrunde, eine Herstellung entsprechender elektronischer Baugruppen auf Wafer-Ebene zu ermöglichen und darüber hinaus sicherzustellen, dass auch bei temperaturempfindlichen Funktionsbauelementen eine zulässige Temperaturbelastung nicht überschritten wird.

Zur Lösung dieser Aufgabe weist die erfindungsgemäße Vorrichtung die Merkmale des Anspruchs 1 auf.

Die erfindungsgemäße Vorrichtung ist mit einem Aufnahmerahmen zur abstützenden Aufnahme eines ersten Wafers auf einer im Aufnahmerahmen angeordneten transparenten Platte und einer durch die transparente Platte vom Wafer getrennt innerhalb des Aufnahmerahmens angeordneten Diodenlaser-Verbundanordnung versehen. Weiterhin weist die erfindungsgemäße Vorrichtung einen Gegenhalter zur Aufnahme eines zweiten Wafers auf, derart, dass die mit Kontaktmetallisierungen versehenen Kontaktflächen der Wafer einander gegenüberliegend angeordnet sind, sowie eine Positioniereinrichtung zur Relativpositionierung der Wafer, derart, dass miteinander zu verbindende Kontaktmetallisierungen Kontaktpaarungen bilden. Darüber hinaus ist die erfindungsgemäße Vorrichtung mit einer Andruckeinrichtung zur Erzeugung eines Kontaktdrucks zwischen den Kontaktmetallisierungen der Kontaktpaarungen versehen.

In einer ersten Ausführungsform der Vorrichtung ist die Diodenlaser-Verbundanordnung als eine Diodenlaser-Linearanordnung ausgeführt mit einer Mehrzahl von in einer Reihe angeordneten Diodenlasern, die auf einem quer zur Ausrichtung der Reihe und parallel zur Erstreckungsebene des Wafers verfahrbaren Diodenlaserträger angeordnet sind.

Darüber hinaus erweist es sich als vorteilhaft, wenn die Diodenlaser der Diodenlaser-Linearanordnung einzeln oder gruppenweise aktivierbar sind, derart, dass zur Beaufschlagung einer kreisflächenförmigen Wafer-Kontaktoberfläche mit der parallel zur Erstreckungsebene des Wafers verfahrbaren Diodenlaser-Linearanordnung lediglich die Diodenlaser der Diodenlaser-Linearanordnung aktivierbar sind, die in Abhängigkeit vom Verfahrweg zur Überdeckung der zugeordneten Quererstreckung der Wafer-Kontaktoberfläche benötigt werden.

Bei einer alternativen Ausführungsform der Vorrichtung ist die Diodenlaser-Verbundanordnung als eine Diodenlaser-Matrix Anordnung mit einer Mehrzahl von jeweils in Reihen und Spalten angeordneten Diodenlasern ausgebildet.

Bei der Diodenlaser-Matrixanordnung erweist es sich als vorteilhaft, wenn die Diodenlaser einzeln oder gruppenweise aktivierbar sind, derart, dass bei einer koaxialen Ausrichtung der Flächenmittelpunkte der Wafer-Kontaktoberfläche und der Matrixfläche die Diodenlaser entsprechend der Größe der Wafer-Kontaktoberfläche in ihrer Gesamtheit oder nur im Umfang einer zur Überdeckung der Wafer-Kontaktoberfläche benötigten Teilmatrix aktivierbar sind.

Zur Überwachung des Kontaktierungsverfahrens erweist es sich als vorteilhaft, wenn in einem durch einen Abstand zwischen der transparenten Platte und der Diodenlaser-Verbundanordnung gebildeten Zwischenraum eine Transmissionseinrichtung angeordnet ist, die zur Messung einer Referenztemperatur dient.

Weiterhin erweist es sich zur Minimierung des zur Kontaktierung benötigte Wärmeeintrags als vorteilhaft, wenn zur Ausrichtung der Kontaktmetallisierungen in einer Überdeckungslage zur Ausbildung der Kontaktpaarungen der dem rückwärtig mit Laserstrahlung beaufschlagten Wafer gegenüberliegende Wafer in einer zumindest zweiachsig verfahrbaren Positioniereinrichtung angeordnet ist.

Wenn die Positioniereinrichtung dreiachsig ausgebildet ist, derart, dass neben einer zweiachsigen Positionierung des Wafers in der Erstreckungsebene des Wafers die Positioniereinrichtung zur Ausführung einer Zustellbewegung quer zur Erstreckungsebene dient, kann die Positioniereinrichtung auch zur Erzeugung des zur Herstellung der Kontaktierung benötigten Kontaktdrucks verwendet werden.

Die beiden jeweils auf ihren einander gegenüberliegenden Kontaktoberflächen mit Kontaktmetallisierungen versehenen Wafer werden zur Ausbildung von Kontaktpaarungen mit ihren Kontaktmetallisierungen in eine Überdeckungslage gebracht, in der die miteinander zu verbindenden Kontaktmetallisierungen gegeneinander gedrückt werden. Die Kontaktierung der Kontaktmetallisierungen erfolgt durch eine rückwärtige Beaufschlagung des einen Wafers mit Laserstrahlung, wobei die Wellenlänge der Laserstrahlung in Abhängigkeit vom Absorptionsgrad des rückwärtig beaufschlagten Wafers so gewählt wird, dass eine Transmission der Laserstrahlung durch den rückwärtig beaufschlagten Wafer im Wesentlichen unterbleibt.

Hierdurch wird sichergestellt, dass eine Erwärmung des mit dem ersten Wafer zu kontaktierenden zweiten Wafers im Wesentlichen über die Kontaktpaare bildenden Kontaktmetallisierungen erfolgt und eine unmittelbare Beaufschlagung des zweiten Wafers durch die Laserstrahlung unterbleibt.

Der durch die Kontaktierung der beiden Wafer geschaffene Waferverbund kann nachfolgend durch Vereinzelung in vereinzelte elektronische Baugruppen bestehend aus einem Chip und einem damit kontaktierten Funktionsbauelement aufgelöst werden.

Wenn die rückwärtig mit Laserstrahlung beaufschlagte Bauelement-Verbundanordnung so gewählt wird, dass eine Transmission der Laserstrahlung durch die rückwärtig mit Laserstrahlung beaufschlagte Bauelement-Verbundanordnung erfolgt und eine Absorption der Laserstrahlung im Wesentlichen lediglich in den Kontaktmetallisierungen der rückwärtig mit Laserstrahlung beaufschlagten Bauelement-Verbundanordnung erfolgt, ist es möglich, die für die Kontaktierung, die grundsätzlich bei dem Verfahren durch Thermokompression oder auch Aushärtung eines Klebers oder andere mögliche Verbindungsarten erfolgen kann, die zur Aktivierung einen Wärmeeintrag benötigen, notwendige Erwärmung der Kontaktmetallisierungen durch eine im Wesentlichen unmittelbare Erwärmung der Kontaktmetallisierungen durchzuführen. Insbesondere dann, wenn die Kontaktmetallisierungen der rückwärtig mit Laserstrahlung beaufschlagten Bauelement-Verbundanordnung aus einem Material gewählt sind, das eine im Vergleich zum Substratmaterial der gegenüberliegend angeordneten Bauelement-Verbundanordnung höhere Wärmekapazität aufweist, kann erreicht werden, dass die für die Kontaktierung erforderliche Temperaturerhöhung im Wesentlichen nur im Bereich der Kontaktmetallisierungen erfolgt.

Ein gleichzeitiger Wärmeeintrag in die Kontaktmetallisierungen der rückwärtig mit Laserstrahlung beaufschlagten Bauelement-Verbundanordnung und die Kontaktmetallisierungen der gegenüberliegend angeordneten Bauelement-Verbundanordnung kann erfolgen, wenn die rückwärtig mit Laserstrahlung beaufschlagte Bauelement-Verbundanordnung so gewählt wird, dass eine Transmission der Laserstrahlung durch die rückwärtig mit Laserstrahlung beaufschlagte Bauelement-Verbundanordnung erfolgt und eine Absorption der Laserstrahlung in den Kontaktmetallisierungen der rückwärtig mit Laserstrahlung beaufschlagten Bauelement-Verbundanordnung und in den im Vergleich zu den Kontaktmetallisierungen der rückwärtig mit Laserstrahlung beaufschlagten Bauelement-Verbundanordnung flächenmäßig größeren Kontaktmetallisierungen der gegenüberliegenden Bauelement-Verbundanordnung erfolgt.

Die Laserbeaufschlagung erfolgt mittels einer Verbundanordnung von mehreren Diodenlasern, die einzeln oder in Gruppen zusammengefasst zur Emission von Laserstrahlung aktiviert werden, derart, dass sämtliche oder in Gruppen zusammengefasste Kontaktpaarungen zur Kontaktierung mit Laserstrahlung beaufschlagt werden.

Zum einen ermöglicht die Verwendung von Laserdioden zur Laserbeaufschlagung des Wafers eine besonders exakte Einstellbarkeit der von der laseraktiven Schicht des Diodenlasers emittierten Wellenlänge, so dass ein entsprechend hoher Absorptionsgrad im rückwärtig beaufschlagten Wafer erreichbar ist. Zum anderen ermöglicht die definierte Aktivierung ausgewählter Diodenlaser aus einer Verbundanordnung eine Laserbeaufschlagung gerade in dem Umfang, wie er zur Kontaktierung benötigt wird. In entsprechender Weise wird der rückwärtig beaufschlagte Wafer nur soweit erwärmt, wie es zur Kontaktierung unbedingt notwendig ist. Damit reduziert sich auch ein möglicher Wärmestrahlungsübergang von dem durch Absorption aufgeheizten ersten Wafer auf den gegenüberliegend zur Kontaktierung vorgesehenen zweiten Wafer.

Wenn die Diodenlaser-Verbundanordnung als Diodenlaser-Linearanordnung ausgebildet ist, die mit Abstand unterhalb des rückwärtig mit Laserstrahlung beaufschlagten Wafers angeordnet ist, derart, dass die Diodenlaser-Linearanordnung zumindest einachsig und parallel zur Erstreckungsebene des Wafers verfahren wird, ist eine relativ geringe Anzahl von Diodenlasern ausreichend.

Alternativ ist es möglich, die Diodenlaser- Verbundanordnung als Diodenlaser-Matrixanordnung auszubilden, wobei die Diodenlaser entsprechend der Größe des rückwärtig mit Laserstrahlung zu beaufschlagenden Wafers in ihrer Gesamtheit oder nur im Umfang einer Teilmatrix aktiviert werden. Dies ermöglicht die gleichzeitige Kontaktierung aller Kontaktpaarungen, so dass die Kontaktierung auf Wafer-Ebene unter minimaler Temperaturbelastung für den weiteren Wafer innerhalb kürzester Zeit durchführbar ist.

Wenn in einem durch den Abstand zwischen dem rückwärtig beaufschlagten Wafer und der Diodenlaser-Verbundanordnung gebildeten Zwischenraum mittels einer von der Laserstrahlung durchdrungenen Transmissionseinrichtung eine Referenztemperatur gemessen wird, ist es möglich, fortlaufend während der Laserbeaufschlagung die Temperatur im rückwärtig beaufschlagten Wafer zu überwachen, um beispielsweise bei Erreichen eines Temperaturschwellwertes die Diodenlaser-Verbundanordnung zumindest kurzzeitig auszuschalten.

Die Vermeidung einer unnötigen Temperaturbelastung des mit dem rückwärtig beaufschlagten Wafer zu kontaktierenden Wafers wird auch unterstützt durch den Einsatz einer zweiachsig und parallel zur Erstreckungsebene des Wafers wirkenden Positionierungseinrichtung zur Ausrichtung der Kontaktmetallisierungen in einer Überdeckungslage und Ausbildung der Kontaktpaare, da bei exakter Relativpositionierung der Kontaktpaare ein geringstmöglicher Wärmeeintrag in den gegenüberliegenden Wafer zur Herstellung der Kontaktierung notwendig ist.

Ein unter Verwendung der vorstehenden Vorrichtung hergestellter Bauteilverbund aus zwei wechselseitig miteinander kontaktierten waferartigen Bauelement-Verbundanordnungen weist eine erste transparente Bauelement-Verbundanordnung aus einer Vielzahl zusammenhängend ausgebildeter transparenter Deckeleinheiten und eine zweite Bauelement-Verbundanordnung aus einer Vielzahl zusammenhängend ausgebildeter Sensoreinheiten mit jeweils mindestens einem Sensor auf, der jeweils auf einer der im Verbund zusammenhängend ausgebildeten Substrateinheiten kontaktiert ist, welche mit Durchkontaktierungen für einen rückwärtigen Kontaktzugriff auf die Sensoreinheit versehen sind. Der vorstehende Aufbau des Bauteilverbunds ermöglicht die Herstellung eines insgesamt abgeschlossenen Sensorchips ohne eine unzulässig hohe Temperaturbelastung des Sensors während des Herstellungsvorgangs.

Für einen hermetisch abgedichteten Aufbau der im zusammenhängenden Verbund erzeugten Sensorchipeinheit erweist es sich als vorteilhaft, wenn jeweils eine einen Sensor ringförmig umschließende Kontaktmetallisierung der Deckeleinheiten mit jeweils einer zugeordneten, den Sensor ringförmig umschließenden Kontaktmetallisierung der Substrateinheiten zur Ausbildung eines Dichtrings kontaktiert ist.

Nachfolgend werden zum Einsatz kommende Vorrichtungsalternativen anhand der Zeichnung beispielhaft erläutert.

Es zeigen:
- **Fig. 1**: eine Vorrichtung zur wechselseitigen Kontaktierung von zwei Wafern in Seitenansicht mit einer unterhalb einer transparenten Platte zur Abstützung und Aufnahme der Wafer angeordneten Diodenlaser-Verbundanordnung;
- **Fig. 2**: eine erste Ausführungsform der in **Fig. 1** dargestellten Vorrichtung mit einer Diodenlaser-Linearanordnung in Draufsicht und in einer Anfangsstellung eines Verfahrweges;
- **Fig. 3**: die in **Fig. 2** dargestellte Diodenlaser-Linearanordnung in einer Mittelstellung des Verfahrweges relativ zum beaufschlagten Wafer;
- **Fig. 4**: eine Ausführungsform der Diodenlaser-Verbundanordnung als Diodenlaser-Matrixanordnung in Draufsicht.

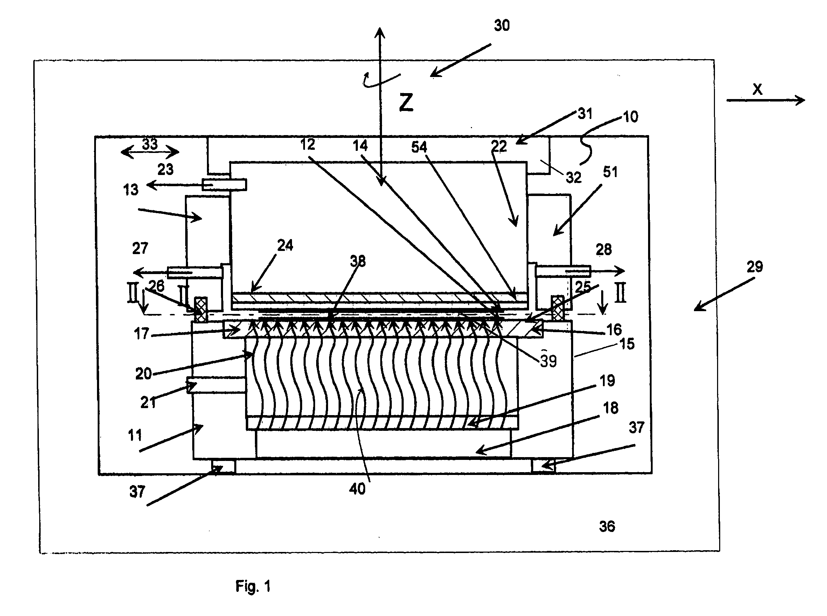

**Fig. 1** zeigt eine Wafer-Kontaktierungsvorrichtung 10 mit einem Aufnahmerahmen 11 zur abstützenden Aufnahme eines ersten, hier als Halbleiter-Wafer 12 ausgeführten Wafers und mit einem Gegenhalter 13 mit einem davon gehaltenen zweiten Wafer, der im vorliegenden Fall als ein Funktionsbauelement-Wafer 14 mit einer Vielzahl darin im Verbund angeordneter Kunststofflinsenteile ausgebildet ist.

Der Aufnahmerahmen 11 besteht aus einem Rahmenzylinder 15, der an seinem oberen Ende einen ringförmigen Absatz 16 aufweist, der zur Aufnahme einer hier als Glasplatte 17 ausgeführten transparenten Platte dient. An seinem der Glasplatte 17 gegenüberliegenden Stirnende ist der Aufnahmerahmen 11 mit einer Diodenlaserverbundanordnung 18 versehen. Oberhalb der Diodenlaserverbundanordnung 18 befindet sich eine Transmissionseinrichtung 19, die von der Diodenlaserverbundanordnung 18 emittierte Laserstrahlung 20 im Wesentlichen absorptionsfrei hindurchtreten lässt und mit zumindest einer hier nicht näher dargestellten Temperatursensoreinrichtung zur Messung einer Referenztemperatur versehen ist. Darüber hinaus ist im Rahmenzylinder 15 umfangsseitig ein Druckanschluss 21 vorgesehen, der eine Beaufschlagung eines zwischen der Glasplatte 17 und der Diodenlaserverbundanordnung 18 bzw. der Transmissionseinrichtung 19 gebildeten Rahmeninnenraums 40 mit Druckluft ermöglicht.

Der im vorliegenden Ausführungsbeispiel ebenfalls einen Rahmenzylinder 51 aufweisende Gegenhalter 13 weist aufgenommen durch den Rahmenzylinder 51 ein druckfestes Gehäuse 22 auf, das mit einem Vakuumanschluss 23 versehen ist. Eine als Gegenhaltefläche 24 dienende Wandung des Gehäuses 22 ist als eine poröse Platte ausgeführt. Der Funktionsbauelement-Wafer 14 wird bei Anlegen eines Vakuums an den Vakuumanschluss 23 gegen die Gegenhaltefläche 24 in der in **Fig. 1** dargestellten Weise gehalten. Bei dem vorliegenden Ausführungsbeispiel ist die poröse Platte mit einer elastischen, porösen Zwischenlage 54 versehen, um lokale Abweichungen in dem zwischen den Kontaktmetallisierungen während der Kontaktierung wirksamen Kontaktdruck ausgleichen zu können.

Wie **Fig. 1** zeigt, wird ein zwischen dem Aufnahmerahmen 11 und dem Gegenhalter 13 gebildeter Prozessraum 25 umfangsseitig durch eine elastische Abdichtung 26 gegenüber der Umgebung abgedichtet. Der Prozessraum 25 ist über Gasanschlüsse 27, 28 mit der Umgebung verbunden. Die Gasanschlüsse 27, 28 ermöglichen das Anlegen eines Vakuums oder beispielsweise auch die Beaufschlagung des Prozessraums 25 mit einem Schutzgas. Eine Vakuumentgasung kann sich beispielsweise beim Einsatz von Klebermaterial als Verbindungsmaterial als vorteilhaft erweisen.

Der Aufnahmerahmen 11 ist zusammen mit dem Gegenhalter 13 in einem umlaufend geschlossenen Maschinenrahmen 29 gehalten. Zur Erzeugung eines zur Kontaktierung von hier nicht näher dargestellten Kontaktmetallisierungen des Halbleiter-Wafers 12 mit Kontaktmetallisierungen des Funktionsbauelement-Wafers 14 notwendigen Kontaktdrucks zwischen den durch jeweils einander gegenüberliegend angeordnete Kontaktmetallisierungen gebildeten Kontaktpaarungen ist zwischen dem Gehäuse 22 und einem Rahmenoberzug 30 des Maschinenrahmens 29 eine Positioniereinrichtung 31 vorgesehen, die einen mit dem Gehäuse 22 verbundenen Gehäuseteil 32 und einen mit dem Rahmenoberzug 30 verbundenen Gehäuseteil 33 aufweist. Neben der zweiachsigen Relativpositionierung des Gehäuseteils 32 gegenüber dem Gehäuseteil 33 um eine senkrecht zur ebenen Erstreckung der Wafer 12, 14 verlaufende Z-Achse und eine parallel zur ebenen Erstreckung der Wafer 12, 14 verlaufende X-Achse 35 ermöglicht die Positioniereinrichtung 31 eine Relativbewegung des Gehäuseteils 32 zum Gehäuseteil 33 in Richtung der Z-Achse und somit eine Zustellbewegung des Funktionsbauelement-Wafers 14 in Richtung auf den Halbleiter-Wafer 12 zur Erzeugung des für die Kontaktierung erforderlichen Kontakt- oder Anpressdrucks.

Zur Kontrolle der Höhe des Anpressdrucks sind über den stirnseitigen Umfang des Aufnahmerahmens 11 verteilt zwischen dem Aufnahmerahmen 11 und einem Rahmenunterzug 36 des Maschinenrahmens 29 Kraftmesszellen 37 angeordnet.

Zur Herstellung der Kontaktierung zwischen den Wafern 12 und 14 wird der Halbleiter-Wafer 12 auf die Glasplatte 17 des Aufnahmerahmens 11 aufgelegt. Die Anlage des Funktionsbauelement-Wafers 14 gegen die Gegenhaltefläche 24 des Gehäuses 22 vom Gegenhalter 13 erfolgt durch Anlegen eines Vakuums an das Gehäuselumen und dem damit verbundenen Ansaugen des Funktionsbauelement-Wafers 14 gegen die als poröse Platte ausgebildete Gegenhaltefläche 24. Nachfolgend erfolgt die exakte Relativpositionierung der Kontaktmetallisierungen auf einer Kontaktoberfläche 38 des Funktionsbauelement-Wafers 14 zu Kontaktmetallisierungen auf einer Kontaktoberfläche 39 des Halbleiter-Wafers 12 durch Ausbildung von Kontaktpaarungen der jeweils einander zugeordneten Kontaktmetallisierungen. Die hierzu erforderliche Ausrichtung erfolgt mittels der Positioniereinrichtung 31 und entsprechender Betätigung von Achsensteuerungen um die Z-Achse und in Richtung der X-Achse.

Die Überwachung der Positionierung kann beispielsweise über ein hier nicht näher dargestelltes optisches Überwachungssystem erfolgen, das in der Lage ist, eine Überdeckung von zumindest zwei voneinander entfernten Kontaktpaarungen zwischen Kontaktmetallisierungen des Halbleiter-Wafers 12 und Kontaktmetallisierungen des Funktionsbauelement-Wafers 14 zu erkennen.

Nach Einstellung der exakten Relativpositionierung wird eine Zustellung des Gegenhalters 13 in Richtung auf den Aufnahmerahmen 11 durch eine Achsensteuerung der Positioniereinrichtung 31 in Richtung der Z-Achse ausgeführt, bis über die Kraftmesszellen 37 das Erreichen des Schwellwertes für den korrekten Anpressdruck erkannt und der entsprechende Achsenantrieb abgeschaltet wird. Zum Ausgleich einer etwaigen Durchbiegung der Glasplatte 17 infolge des Anpressdrucks kann der Innenraum 40 des Aufnahmerahmens 11 über den Druckanschluss 41 mit einem Fluiddruck, also einem Gasdruck oder einem Flüssigkeitsdruck, beaufschlagt werden. Wenn somit sichergestellt ist, dass sämtliche Kontaktpaarungen mit dem zur Kontaktierung erforderlichen Anpressdruck gegeneinander liegen, erfolgt eine Betätigung der Diodenlaserverbundanordnung 18, die je nach Ausführung der Diodenlaserverbundanordnung 18 auf unterschiedliche Art und Weise erfolgen kann.

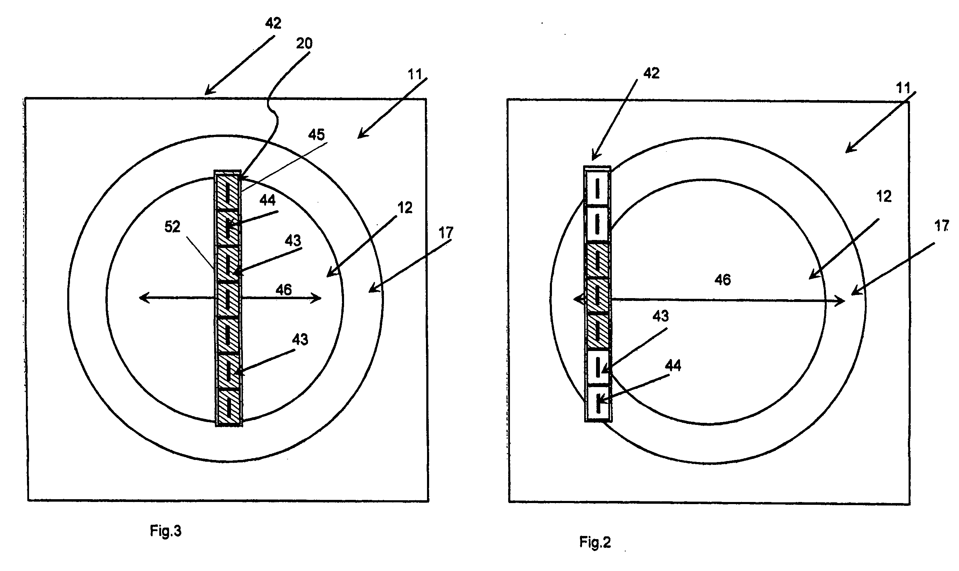

In den **Fig. 2** und **3** ist eine Draufsicht auf den Aufnahmerahmen 11 entsprechend dem Schnittlinienverlauf II-II in **Fig. 1** dargestellt. Zu erkennen ist der lediglich hinsichtlich seiner Umrisskonturen dargestellte Halbleiter-Wafer 12, der auf der Glasplatte 17 des Aufnahmerahmens 11 angeordnet ist und rückwärtig mittels einer Diodenlaser-Linearanordnung 42 mit Laserstrahlung 20 beaufschlagt wird. Im vorliegenden Fall umfasst die Diodenlaser-Linearanordnung 42 sieben auf einem Diodenlaserträger 52 angeordnete Laserdioden 43, die entsprechend ihrer typischen geschichteten Ausbildung mit einer laseraktiven Schicht jeweils einen näherungsweise im Querschnitt rechteckförmigen Strahlengang 44 emittieren, der zu einer Strahlquerschnittsfläche 45 aufgeweitet, die regelmäßig bis zu mehreren Quadratzentimetern groß ist, rückwärtig auf den Halbleiter-Wafer 12 auftrifft und je nach Anschlussflächendichte des Halbleiter-Wafers 12 eine größere Anzahl von Anschlussflächen gleichzeitig mit Laserstrahlung beaufschlagt.

Die Diodenlaser-Linearanordnung 42 ist mit einer hier nicht näher erläuterten Ansteuerung versehen, die es ermöglicht, die Diodenlaser 43 der Diodenlaser-Linearanordnung 42 einzeln oder gruppenweise zusammengefasst zu aktivieren. Zur rückwärtigen Beaufschlagung der gesamten Kontaktoberfläche des Halbleiter-Wafers 12 wird die Diodenlaser-Linearanordnung 42 ausgehend von der in **Fig. 2** dargestellten Anfangsposition über den gesamten Durchmesser des Halbleiter-Wafers 12 verfahren. Dabei werden jeweils nur diejenigen und so viele Diodenlaser 43 in Abhängigkeit vom Verfahrweg 46 aktiviert, um quer zum Verfahrweg 46 den jeweiligen Durchmesser des Halbleiter-Wafers 12 überdecken zu können. So zeigt im hier dargestellten Ausführungsbeispiel die **Fig. 2** die in der Anfangsposition befindliche Diodenlaser-Linearanordnung 42 mit lediglich drei aktivierten Diodenlasern 43 und die **Fig. 3****,** in der eine mittlere Position der Diodenlaser-Linearanordnung 42 längs des Verfahrweges 46 dargestellt ist, eine Aktivierung sämtlicher Diodenlaser 43 der Diodenlaser-Linearanordnung 42.

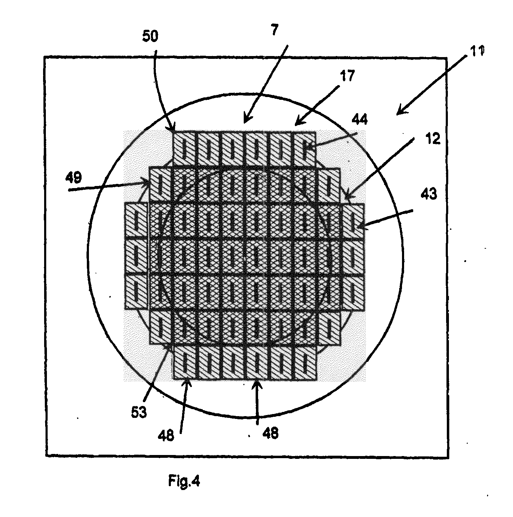

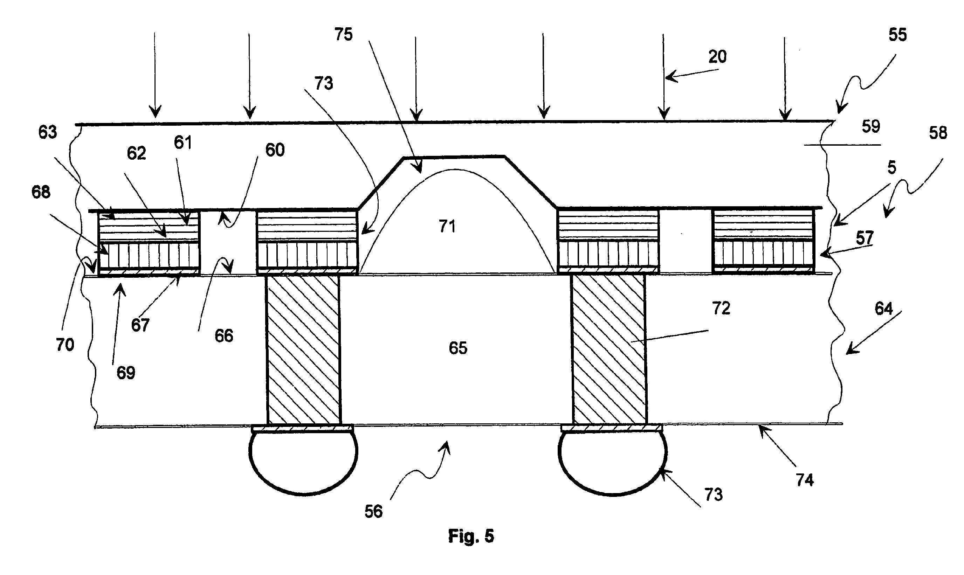

**Fig. 4** zeigt eine Diodenlaser-Matrixanordnung 47 mit zehn Diodenlaser-Spalten 48 und sieben Diodenlaser-Reihen 49. Zur Anpassung an die grundsätzlich kreisflächenförmige Ausbildung des Halbleiter-Wafers 12 und wegen der rechteckförmigen Ausbildung der Strahlquerschnittsfläche 45 ist die Matrix der Diodenlaser-Matrixanordnung 47 unregelmäßig ausgebildet, um die gesamte Kontaktoberfläche 39 des Halbleiter-Wafers 12 mit Laserstrahlung beaufschlagen zu können.

Wie in **Fig. 4** durch die kreuzschraffierte Darstellung eines Teils der Strahlquerschnittsflächen 45 der Diodenlaser 43 verdeutlicht, ist es zur Laserbeaufschlagung eines gegenüber dem Halbleiter-Wafer 12 im Durchmesser reduzierten Halbleiter-Wafers 50 ausreichend, nur einen Teil der Diodenlaser 43 entsprechend einer Teilmatrix 53 zu aktivieren.

## Patentansprüche

1. Vorrichtung zur wechselseitigen Kontaktierung von zwei waferartigen Bauelement-Verbundanordnungen (12, 14) aus einer Vielzahl zusammenhängend ausgebildeter gleichartiger Bauelemente, insbesondere eines Halbleiter-Wafers mit einem Funktionsbauelement-Wafer, zur Herstellung von elektronischen Baugruppen, mit einem Aufnahmerahmen (11) zur abstützenden Aufnahme der ersten Bauelement-Verbundanordnung (12) auf einer im Aufnahmerahmen angeordneten transparenten Platte (17), einer durch die transparente Platte von der Bauelement-Verbundanordnung (12) getrennt innerhalb des Aufnahmerahmens angeordneten Diodenlaser-Verbundanordnung (18, 42, 47) mit mehreren Diodenlasern, die einzeln oder in Gruppen zusammengefasst zur Emission von Laserstrahlung aktiviert werden können, derart, dass sämtliche oder in Gruppen zusammengefasste Kontaktpaarungen zur Kontaktierung mit Laserstrahlung beaufschlagt werden können, mit einem Gegenhalter (13) zur Aufnahme der zweiten Bauelement-Verbundanordnung (14), derart, dass mit Kontaktmetallisierungen versehene Kontaktoberflächen (38, 39) der Bauelement-Verbundanordnungen einander gegenüberliegend angeordnet sind, mit einer Positioniereinrichtung (31) zur Relativpositionierung der Bauelement-Verbundanordnungen, derart, dass die miteinander zu verbindenden Kontaktmetallisierungen Kontaktpaarungen bilden, und mit einer Andruckeinrichtung (31) zur Erzeugung eines Kontaktdrucks zwischen den Kontaktmetallisierungen der Kontaktpaarungen.

2. Vorrichtung nach Anspruch 1,
**dadurch gekennzeichnet,**
**dass** die Diodenlaser-Verbundanordnung als eine Diodenlaser-Linearanordnung (42) mit einer Mehrzahl von in einer Reihe angeordneten Diodenlasern (43) ausgebildet ist, die auf einem quer zur Ausrichtung der Reihe und parallel zur Erstreckungsebene der Bauelement-Verbundanordnung (12) verfahrbaren Diodenlaserträger angeordnet sind.

3. Vorrichtung nach Anspruch 2,
**dadurch gekennzeichnet,**
**dass** die Diodenlaser (43) der Diodenlaser-Linearanordnung (42) einzeln oder gruppenweise aktivierbar sind, derart, dass zur Beaufschlagung einer kreisflächenförmigen Kontaktoberfläche (38) der Bauelement-Verbundanordnung (12) mit der parallel zur Erstreckungsebene der Bauelement-Verbundanordnung verfahrbaren Diodenlaser-Linearanordnung lediglich die Diodenlaser der Diodenlaser-Linearanordnung aktivierbar sind, die in Abhängigkeit vom Verfahrweg (46) zur Überdeckung der zugeordneten Quererstreckung der Kontaktoberfläche der Bauelement-Verbundanordnung benötigt werden.

4. Vorrichtung nach Anspruch 3,
**dadurch gekennzeichnet,**
**dass** die Diodenlaser-Verbundanordnung als eine Diodenlaser-Matrixanordnung (47) mit einer Mehrzahl von jeweils in Reihen und Spalten angeordneten Diodenlasern (43) ausgebildet ist.

5. Vorrichtung nach Anspruch 4,
**dadurch gekennzeichnet,**
**dass** die Diodenlaser (43) der Diodenlaser-Matrixanordnung (47) einzeln oder gruppenweise aktivierbar sind, derart, dass bei einer koaxialen Ausrichtung der Flächenmittelpunkte der Kontaktoberfläche (38) der Bauelement-Verbundanordnung (12) und der Matrixfläche zur Beaufschlagung der kreisflächenförmigen Kontaktoberfläche die Diodenlaser entsprechend der Größe der Kontaktoberfläche in ihrer Gesamtheit oder nur im Umfang einer zur Überdeckung der Kontaktoberfläche benötigten Teilmatrix aktivierbar sind.

6. Vorrichtung nach einem der Ansprüche 1 bis 5,
**dadurch gekennzeichnet,**
**dass** in einem durch einen Abstand zwischen der transparenten Platte (17) und der Diodenlaser-Verbundanordnung (18, 42, 47) gebildeten Zwischenraum eine Transmissionseinrichtung (19) angeordnet ist, die zur Messung einer Referenztemperatur dient.

7. Vorrichtung nach einem der Ansprüche 1 bis 6,
**dadurch gekennzeichnet,**
**dass** zur Ausrichtung der Kontaktmetallisierungen in einer Überdeckungslage zur Ausbildung der Kontaktpaarungen die der rückwärtig mit Laserstrahlung beaufschlagten Bauelement-Verbundanordnung (12) gegenüberliegende Bauelement-Verbundanordnung (14) in einer zumindest zweiachsig verfahrbaren Positioniereinrichtung (31) angeordnet ist.

8. Vorrichtung nach Anspruch 7,
**dadurch gekennzeichnet,**
**dass** die Positioniereinrichtung (31) dreiachsig ausgebildet ist, derart, dass neben einer zweiachsigen Positionierung der Bauelement-Verbundanordnung (14) in der Erstreckungsebene der Bauelement-Verbundanordnung die Positioniereinrichtung zur Ausführung einer Zustellbewegung quer zur Erstreckungsebene dient, derart, dass die Positioniereinrichtung zur Erzeugung des Kontaktdrucks dient.

## Claims

1. A device for alternately contacting two wafer-like component composite arrangements (12, 14) consisting of a plurality of cohesively designed similar components, in particular of a semiconductor wafer having a function component wafer, for manufacturing electronic modules, having a receiving frame (11) for receiving and holding the first component composite arrangement (12) on a transparent panel (17) arranged in the receiving frame, having a diode laser composite arrangement (18, 42, 47) arranged inside the receiving frame separated from the component composite arrangement (12) by the transparent panel and comprising multiple diode lasers that can be activated to emit laser radiation either individually or in groups, such that all the contact pairs or the contact pairs that are combined into groups can be exposed to laser radiation for contacting, having a holding clamp (13) for receiving the second component composite arrangement (14) such that contact surfaces (38, 39) of the component composite arrangements provided with contact metallisations are arranged opposite one another, having a positioning device (31) for relative positioning of the component composite arrangements such that the contact metallisations to be joined together form contact pairs, and having a pressure device (31) for generating a contact pressure between the contact metallisations of the contact pairs.

2. The device according to Claim 1,
**characterised in that**
the diode laser composite arrangement is designed as a diode laser linear arrangement (42) having a plurality of diode lasers (43) arranged in a row which diode lasers are arranged on a diode laser mount that can be moved across the alignment of the row and in parallel to the plane of extent of the component composite arrangement (12).

3. The device according to Claim 2,
**characterised in that**
the diode lasers (43) of the diode laser linear arrangement (42) can be activated individually or in groups in such a way that only the diode lasers of the diode laser linear arrangement which are needed for coverage of the respective transverse extent of the contact surface of the component composite arrangement as a function of the distance (46) to be traversed can be activated for acting upon a circular contact surface (38) of the component composite arrangement (12) with the diode laser linear arrangement that can be moved in parallel to the plane of extent of the component composite arrangement.

4. The device according to Claim 3,
**characterised in that**
the diode laser composite arrangement is designed as a diode laser matrix arrangement (47) having a plurality of diode lasers (43) each arranged in rows and columns.

5. The device according to Claim 4,
**characterised in that**
the diode lasers (43) of the diode laser matrix arrangement (47) can be activated individually or in groups such that with a coaxial alignment of the surface midpoints of the contact surface (38) of the component composite arrangement (12) and of the matrix surface for acting upon the circular contact surface, the diode lasers can be activated according to the size of the contact surface either in a totality or only to the extent of a partial matrix required for coverage of the contact surface.

6. The device according to any one of Claims 1 through 5,
**characterised in that**
a transmission device (19) which serves to measure a reference temperature is provided in an intermediate space formed by a distance between the transparent panel (17) and the diode laser composite arrangement (18, 42, 47).

7. The device according to any one of Claims 1 through 6,
**characterised in that**
for alignment of the contact metallisations in a coverage position to form the contact pairs, the component composite arrangement (14) opposite the component composite arrangement (12) that is exposed to laser radiation at the rear is arranged in a positioning device (31) that can be moved in at least two axes.

8. The device according to Claim 7,
**characterised in that**
the positioning device (31) is designed to be triaxial such that in addition to a biaxial positioning of the component composite arrangement (14) in the plane of extent of the component composite arrangement, the positioning device serves to execute an advancing movement across the plane of extent such that the positioning device serves to create the contact pressure.

## Revendications

1. Dispositif pour mettre en contact alternatif deux agencements composites de composants (12, 14) en forme de tranche composés d'une pluralité de composants similaires formés cohérents, en particulier d'une tranche de semi-conducteur avec une tranche de composant fonctionnel, pour fabriquer des modules électroniques, comprenant un cadre de logement (11) pour loger de manière supportant le premier agencement composite de composants (12) sur une plaque transparente (17) disposée dans le cadre de logement, un agencement composite de diodes laser (18, 42, 47) étant disposé dans le cadre de logement de manière séparée de l'agencement composite de composants (12) par la plaque transparente et ayant plusieurs diodes laser qui peuvent être activées individuellement ou de manière réunie en groupe pour l'émission du rayonnement laser de telle manière que toutes les paires de contact ou les paires de contact réunies en groupe puissent être exposées au rayonnement laser en vue d'une mise en contact, comprenant un contre-appui (13) pour loger le deuxième agencement composite de composants (14) de telle manière que des surfaces de contact (38, 39) des agencements composites de composants pourvues de métallisations de contact soient disposées de manière opposée, comprenant un dispositif de positionnement (31) pour le positionnement relatif des agencements composites de composants de telle manière que les métallisations de contact destinées à être connectées l'une à l'autre forment des paires de contact, et comprenant un dispositif de pression (31) pour générer une pression de contact entre les métallisations de contact des paires de contact.

2. Dispositif selon la revendication 1,
**caractérisé en ce que**
l'agencement composite de diodes laser est réalisé comme agencement linéaire de diodes laser (42) ayant une pluralité de diodes laser (43) disposées dans une rangée qui sont disposées sur un porteur de diodes laser qui peut être déplacé transversalement par rapport à l'orientation de la rangée et parallèlement au plan d'étendue de l'agencement composite de composants (12).

3. Dispositif selon la revendication 2,
**caractérisé en ce que**
les diodes laser (43) de l'agencement linéaire de diodes laser (42) peuvent être activées individuellement ou de manière réunie en groupe de telle manière que pour le traitement d'une surface de contact en forme de surface circulaire (38) de l'agencement composite de composants (12) par l'agencement linéaire de diodes laser déplaçable parallèlement au plan d'étendue de l'agencement composite de composants, seulement les diodes laser de l'agencement linéaire de diodes laser puissent être activées qui sont nécessaires pour le recouvrement de l'étendue transversale associée de la surface de contact de l'agencement composite de composants en fonction de la course de déplacement (46).

4. Dispositif selon la revendication 3,
**caractérisé en ce que**
l'agencement composite de diodes laser est réalisé comme agencement matriciel de diodes laser (47) ayant une pluralité de diodes laser (43) respectivement disposées en lignes et colonnes.

5. Dispositif selon la revendication 4,
**caractérisé en ce que**
les diodes laser (43) de l'agencement matriciel de diodes laser (47) peuvent être activées individuellement ou en groupes de telle manière qu'en cas d'une orientation coaxiale des centres de surface de la surface de contact (38) de l'agencement composite de composants (12) et de la surface matricielle pour le traitement de la surface de contact en forme de surface circulaire, les diodes laser puissent être activées dans leur intégralité ou seulement dans la mesure d'une matrice partielle nécessaire pour le recouvrement de la surface de contact correspondant à la grandeur de la surface de contact.

6. Dispositif selon l'une quelconque des revendications 1 à 5,
**caractérisé en ce qu'**
un dispositif de transmission (19) est disposé dans un espace intermédiaire formé par une distance entre la plaque transparente (17) et l'agencement composite de diodes laser (18, 42, 47), ledit dispositif de transmission servant à mesurer une température de référence.

7. Dispositif selon l'une quelconque des revendications 1 à 6,
**caractérisé en ce que**
pour ajuster les métallisations de contact dans une position de recouvrement pour former les paires de contact, l'agencement composite de composants (14) disposé en sens opposé de l'agencement composite de composants (12) exposé au rayonnement laser par l'arrière est disposé dans un dispositif de positionnement (31) déplaçable sur au moins deux axes.

8. Dispositif selon la revendication 7,
**caractérisé en ce que**
le dispositif de positionnement (31) est réalisé avec trois axes de telle manière qu'en plus d'un positionnement biaxial de l'agencement composite de composants (14) dans le plan d'étendue de l'agencement composite de composants, le dispositif de positionnement serve à effectuer un mouvement d'avance transversalement au plan d'étendue de telle manière que le dispositif de positionnement serve à générer la pression de contact.
